Europäisches Patentamt

European Patent Office

Office européen des brevets

(11) Publication number: **0 257 774**
**A1**

## (12) EUROPEAN PATENT APPLICATION

(21) Application number: **87306370.5**

(22) Date of filing: **17.07.87**

(51) Int. Cl.⁴: **H01L 27/02**

(30) Priority: **24.07.86 JP 174766/86**

(43) Date of publication of application:
**02.03.88 Bulletin 88/09**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Taira, Shigenobu**
**18-20 Sasao Nishi 1-chome**
**Toin-cho Inabe-gun Mie 511-02(JP)**

(74) Representative: **Rackham, Stephen Neil et al**
**GILL JENNINGS & EVERY 53-64 Chancery**
**Lane**
**London WC2A 1HN(GB)**

(54) **Protection circuit for large-scale integrated circuit.**

(57) A protection circuit for a large-scale integrated circuit includes a metal insulator semiconductor transistor (Q1) to be protected, a resistor (R1) connected between an external terminal (I) and the gate of the transistor (Q1) to be protected, a protecting transistor (Q3) having a base which is a well region of a substrate of the large-scale integrated circuit, and an auxiliary transistor (Q4) connected between the base of the protecting transistor (Q3) and a voltage source ($V_{SS}$). The auxiliary transistor (Q4) causes the base of the protecting transistor (Q3) to become a floating state when the large-scale integrated circuit is not energized by a power source ($V_{CC}$) and causes the base of the protecting transistor (Q3) to become conductive with the voltage source ($V_{SS}$) when the large-scale integrated circuit is energized by the power source ($V_{CC}$).

Fig. 6

## Protection Circuit For Large-Scale Integrated Circuit

The present invention relates to a protection circuit for a large-scale integrated circuit. The protection circuit according to the present invention is used, for example, for a large-scale integrated circuit using complementary metal insulator semiconductor (CMIS) transistors.

A protection circuit is provided for a large-scale integrated circuit to prevent destruction of the transistors in the integrated circuit by an abnormal high voltage caused by electrostatic charging. Electrostatic charging is caused, during the process of manufacture of an integrated circuit, by contact between a human body, which can carry an electrostsatic charge having a potential of, for example, 500 to 1000 volts, and a terminal of the integrated circuit, or by contact between the moulded package of the integrated circuit, which can carry an electrostatic charge having a potential of, for example, several thousand volts, accumulated during, for example, mark stamping by a rubber roll type stamping appliance, and a terminal of the integrated circuit.

Various types of prior art protection circuits have been proposed in which a combination of an input resistor and a protecting transistor is used.

One such example of a protection circuit comprises

a metal insulator semiconductor transistor to be protected;

a resistor connected between an external terminal and the transistor to be protected;

a protecting transistor having a first electrode connected with the junction of the gate of the transistor to be protected and the resistor, and a second connected to a voltage source; and,

an auxiliary transistor connected between a third electrode of the protecting transistor and the voltage source.

However, such prior art protection circuits are not considered satisfactory, since a problem sometimes arises in that the value of the voltage at which the protection operation against the abnormal high voltage begins is too high, or where a very thin gate insulation layer is used for the transistor to be protected, protection cannot be maintained against repeated applications of an abnormal high voltage.

According to this invention in such a protection circuit the first electrode of the protecting transistor is a collector, the second electrode is an emitter and the third electrode is a base formed in a well region formed in the substrate of the large-scale integrated circuit;

and the auxiliary transistor causes the base of the protecting transistor to have a floating state when the large-scale integrated circuit is not energized by a power source and causes the base of the protecting transistor to become conductive with the voltage source when the large-scale integrated circuit is energized by the power source.

In the protection circuit of the present invention the protection operation against an abnormal high voltage is set at a suitable voltage value and the protection operation can be reliably carried out against repeated applications of such an abnormal high voltage even where a very thin gate insulation layer is used for the transistor to be protected.

Particular embodiments of the present invention will now be described and contrasted with the prior art with reference to the accompanying drawings; in which:-

Figures 1 and 2 are circuit diagrams of two types of prior art protection circuit for a large-scale integrated circuit;

Figure 3 is a cross-section through the prior art protection circuit shown in Figure 2;

Figure 4 is a graph showing the operational characteristics of the protection circuits;

Figure 5 shows a cross-section through a protection circuit for a large-scale integrated circuit according to an embodiment of the present invention;

Figure 6 is a circuit diagram of the device shown in Figure 5;

Figure 7 is a graph showing the operational characteristics of the protecting transistor;

Figure 8 is a plan of an example of an actual pattern of a protection circuit for a large-scale integrated circuit according to an embodiment of the present invention;

Figure 9 is a cross-section through another embodiment of the present invention;

Figure 10 is a circuit diagram of the device shown in Figure 7; and,

Figure 11 shows still another embodiment of the present invention.

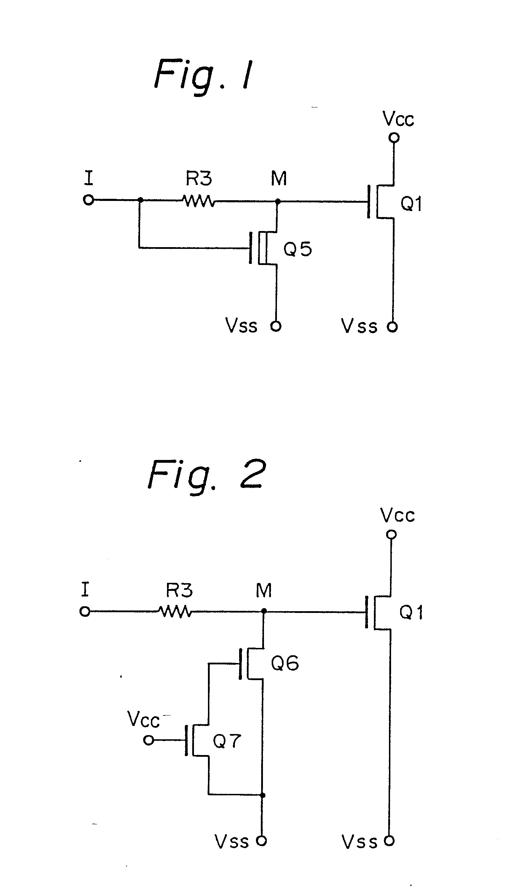

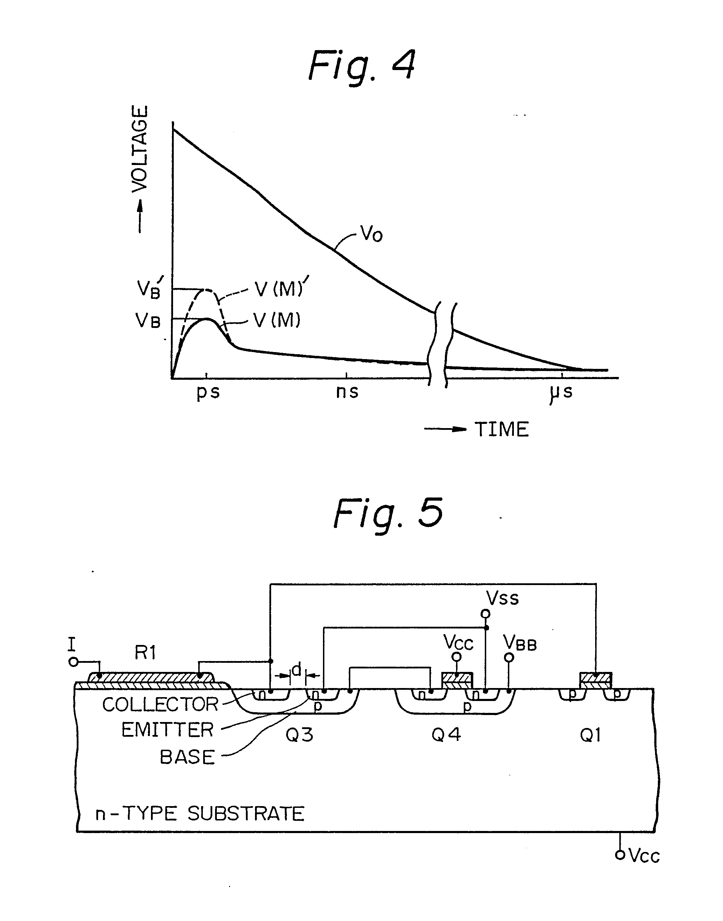

Before describing the preferred embodiments of the present invention, prior art protection circuits for a large-scale integrated circuit as illustrated in Figures 1, 2, and 3, and the operation of a prior art protection circuit will be explained, with reference to Figure 4. A first example of a prior art protection circuit is shown in Figure 1.

In the device of Figure 1, an input resistor R3 is connected between an input terminal I and the gate of the transistor Q1 to be protected. A field transistor Q5 for protection, the gate insulation layer of which is a field insulation layer having a thickness of several thousands of angstroms and formed on the semiconductor substrate, is connected between one terminal M of the resistor R3 and the voltage source $V_{SS}$. THe gate of the field transistor Q5 is connected to the input terminal I. The threshold voltage of the field transistor Q5 is relatively large, for example, 20 volts.

In the device of Figure 1, when an abnormal high voltage $V_0$ of several hundreds volts is applied to the input terminal I, the transistor Q5 is turned ON, and the applied abnormal high voltage $V_0$ is discharged to the voltage source $V_{SS}$ at ground potential, which can absorb a large amount of electrostatic charge. After the transistor Q5 is turned ON, the applied abnormal high voltage $V_0$ is voltage-divided according to the ratio of the resistance of the transistor Q5 to the resistance of the resistor R3. Thus the voltage at the terminal M of the resistor R3, which is the voltage of the gate of the transistor Q1, is lowered, and the transistor Q1 is protected. The resistor R3 has a resistance of, for example, several kilo-ohms or less.

When the device of Fig. 1 is operated under a regular condition, the field transistor Q5 does not turn ON, and accordingly, the regular operation of the device of Fig. 1 is not prevented.

However, in the device of Fig. 1, a problem arises in that the value of the voltage at which the protection operation against the abnormal high voltage begins is too high.

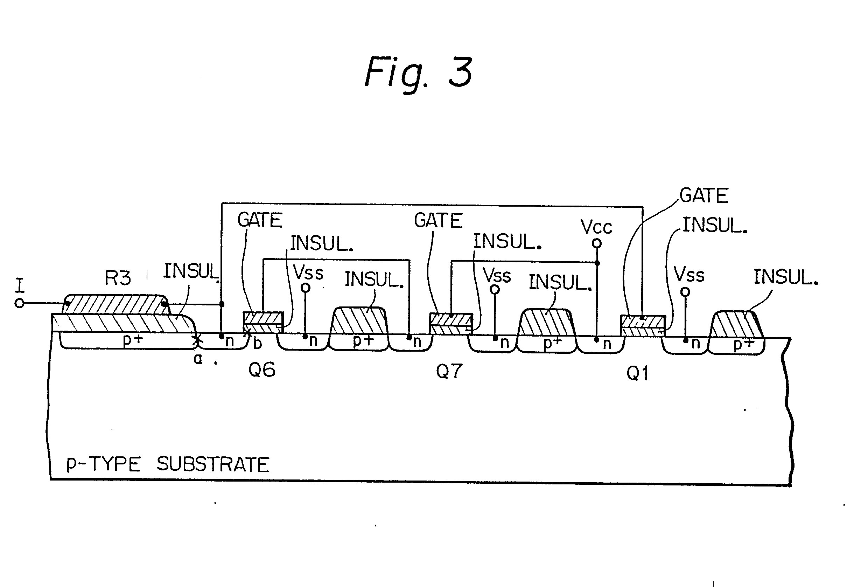

A second example of a prior art protection circuit is shown in Fig. 2, and a cross-section of the structure of the device of Fig. 2 is shown in Fig. 3. In the device of Fig. 2, an input resistor R3 is connected between an input terminal I and the gate of the transistor Q1 to be protected, and a protecting transistor Q6 is connected between one terminal M of the resistor R3 and the voltage source $V_{SS}$. An auxiliary transistor Q7 is connected between the gate of the transistor Q6 and the voltage source $V_{SS}$. The gate of the transistor Q7 is connected to the voltage source $V_{CC}$. When the device of Fig. 2 is operated under the regular condition, the gate of the transistor Q7 is supplied with the voltage $V_{CC}$ to turn the transistor Q7 ON, but the transistor Q6 is turned OFF. Accordingly, the regular operation of the device of Fig. 2 is fundamentally not prevented.

In the device of Fig. 2, when an abnormal high voltage $V_0$ is applied to the input terminal I and the potential V(M)' of the terminal M of the resistor R3, which is applied to the protecting transistor Q6, becomes larger than the breakdown voltage of the protecting transistor Q6, the transistor Q6 is turned ON, as shown by the broken line curve V(M)' in Fig. 4, and the abnormal high voltage $V_0$ is discharged to the voltage source $V_{SS}$. After the transistor Q6 is turned ON, the applied abnormal high voltage $V_0$ is voltage-divided according to the ratio of the resistance of the transistor Q6 to the resistance of the resistor R3. Thus the voltage V(M)' at the terminal M of the resistor R3, which is the voltage of the gate of the transistor Q1, is lowered, and the protection of the transistor Q1 is realized.

In Fig. 4, the characteristics of the operation of the protection circuit are illustrated. The time from the application of an abnormal high voltage $V_0$ to the realization of the breakdown voltage $V_B'$ is on the order of pico-seconds. The time in which the abnormal high voltage $V_0$ falls to the lowest value is nearly the transient time $\tau$ which is less than 1 micro-second.

In the cross-sectional view of Fig. 3, the resistor layer R3 of polycrystalline silicon (poly-silicon) is formed on a silicon dioxide insulation layer formed on the substrate. The gate of the protecting transistor Q6 is formed on a silicon dioxide insulation layer formed on the substrate to bridge two n-type regions, and the gate of the auxiliary transistor Q7 is formed on a silicon dioxide insulation layer formed on the substrate to bridge two n-type regions. The gate of the transistor Q1 to be protected is formed on a silicon dioxide insulation layer formed on the substrate to bridge two n-type regions.

In the structure of Fig. 3, field insulation layers of silicon dioxide are formed on the surface of the p type substrate, between the transistors Q6 and Q7 and between the transistor Q7 and Q1. A $p^+$ type channel-cut region is formed beneath each of these field insulation layers and the insulation layer beneath the resistor R3.

In the structure of Fig. 3, a problem arises in that the border part "a" between the $p^+$ type channel-cut region below the resistor R3 and the n-type source region is apt to be destroyed by the abnormal high voltage, and that the gated junction "b" between the n-type source region and the insulation layer beneath the gate of the transistor Q6 is apt to be destroyed.

In the structure of Fig. 3, in order to attain the protection effect, it is necessary to reduce the breakdown voltage $V_B$ of the transistor Q6, for example, to less than 20 volts. This is because, since recently the thickness of a large-scale integrated circuit has been reduced in correspondence with the increase of the degree of integration, the thickness of the gate insulation layer of the transistor Q1 to be protected has been reduced to the order of 200 angstroms, which reduces the gate breakdown voltage of the transistor Q1 to, for example, 20 volts. Accordingly, to achieve the protection of the transistor Q1, it is necessary to reduce the breakdown voltage $V_B'$ of the protecting transistor Q6 to, for example, less than 20 volts.

In order to reduce the breakdown voltage $V_B'$ of the transistor Q6, it is necessary to reduce the thickness of the gate insulation layer of the transistor Q6.

However, a problem arises in that, if the thickness of the gate insulation layer of the transistor Q6 is thus reduced, the above-described border destruction or the gated junction destruction may occur because of a first abnormal high voltage, and after the destruction by the first abnormal high voltage, the device of Fig. 3 can no longer carry out a protection operation. Accordingly, in the device of Fig. 2, a problem arises in that the protection operation against repeated applications of an abnormal high voltage cannot be realized.

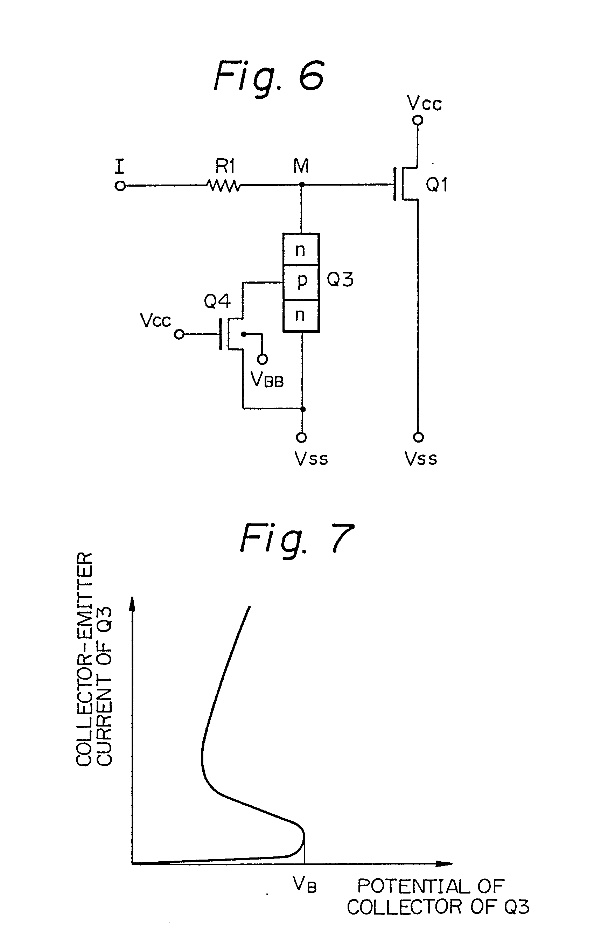

A protection circuit for a large-scale integrated circuit according to an embodiment of the present invention is shown in Figs. 5 and 6. The cross-sectional structure is shown in Fig. 5, and the equivalent circuit of the structure of Fig. 5 is shown in Fig. 6.

In the substrate of the large-scale integrated circuit are arranged a resistor R1, a protecting transistor Q3, an auxiliary transistor Q4, and a metal insulator semiconductor transistor Q1 to be protected. The substrate of semiconductor is n-type. The resistor R1 is constituted by a layer of polycrystalline silicon (poly-silicon) deposited on the insulation layer of silicon dioxide ($SiO_2$) formed on the substrate. The resistance of the resistor R1 is, for example, 500 to 3000 ohms. The protecting transistor Q3 is a bipolar lateral transistor of an npn type formed in a well region of the substate. The p-region, the left n-region, and the right n-region act as the base, the collector, and the emitter, respectively.

The auxiliary transistor Q4 is an n-channel MIS transistor, and the metal insulator semiconductor transistor Q1 is a transistor in the large-scale integrated circuit to be protected according to the present invention. The transistor Q4 has an n-type source and an n-type drain formed in a p-type well in the substrate. The p-type well for the transistor Q4 can be formed simultaneously with the formation of the base of the protecting transistor Q3. The n-type source and drain can be formed simultaneously with the formation of the collector and emitter of the protecting transistor Q3. The transistor Q1 is a MIS type, having a source and a drain, both p type, an insulation layer, and a gate.

The left terminal of the resistor R1 is connected to the input terminal I, and the right terminal of the resistor R1 is connected to the collector of Q3 and the gate of Q1. The base of Q3 is connected to a source (or drain) of Q4. The emitter of Q3 and the drain (or source) of Q4 are connected to a voltage source $V_{SS}$ having ground potential.

The p-region of Q4 is connected to a voltage source $V_{BB}$ having a substrate bias function or a voltage source $V_{SS}$. The gate of Q4 and the substrate are connected to a voltage source $V_{CC}$.

It is assumed that the device of Fig. 5 is constructed as a large-scale integrated circuit having a high degree of integration. Therefore, the thickness of the gate insulation layer of the transistor Q1 to be protected is as small as, for example, 200 angstroms, so that the gate breakdown voltage of the transistor Q1 is as low as, for example, 20 volts. Accordingly, the breakdown voltage of the protecting transistor Q3 must be made less than 20 volts to realize the protection operation.

The equivalent circuit of the device shown in Fig. 5 is shown in Fig. 6. The drain and source of the transistor Q1 to be protected are connected to the voltage sources $V_{CC}$ and $V_{SS}$, respectively. The terminal M of the resistor R1 is connected to the gate of the transistor Q1. The collector and emitter of the protecting transistor Q3 are connected to M and the voltage source $V_{SS}$, respectively, and the drain and the source of the auxiliary transistor Q4 are connected to the base of the protecting transistor Q3 and the voltage source $V_{SS}$. The gate of the auxiliary transistor Q4 is connected to the voltage source $V_{CC}$.

The operation of the device of Fig. 5 will now be described. When the large-scale integrated circuit of Fig. 5 is in operation, the auxiliary transistor Q4 is ON since $V_{CC}$ is supplied to the gate, but the protecting transistor Q3 is OFF. Accordingly, in this condition, the protecting operation is not carried out.

Where the large-scale integrated circuit of Fig. 5 is not in operation, the base of the protecting transistor Q3 is in the floating state. It is assumed that an abnormal electrostatic voltage $V_0$ is applied to the input terminal I, which causes a similar abnormal high voltage to be applied to M. When this high voltage at M becomes greater than the collector-emitter breakdown voltage $BV_{CEO}$ of the protecting transistor Q3, the protecting transistor Q3 is made ON to conduct between M and $V_{SS}$, so that the applied abnormal high voltage $V_0$ is discharged to the voltage source $V_{SS}$. Thus, the protection operation of the device of Fig. 5 is realized.

The relationship between the potential of the collector and the collector-emitter current of the protecting transistor Q3 is shown in Fig. 7. The operation of the protecting transistor Q3 is similar to that of a thyristor.

When the abnormal high voltage $V_0$ is applied to the collector of the protecting transistor Q3, the potential V(M) of the collector of the transistor Q3 is raised. Since the base of the transistor Q3 is in a floating state, according to the rise of potential of the collector of the transistor Q3, the potential of the base of the transistor Q3 is raised correspondingly. According to the rise of the potential of the base of the transistor Q3, the potential difference between the base and the emitter is made conductive in the direction from the base to the emitter. In this condition, when the voltage becomes greater than the breakdown voltage $V_B$(corresponding to the collector-emitter breakdown voltage $BV_{CEO}$), the protecting transistor Q3 is turned ON to carry out a discharge to the voltage source $V_{SS}$, as shown by the solid line curve V(M) in Fig. 4. The breakdown voltage $V_B$ is, for example, 20 V, which is less than the 30 V breakdown voltage $V_B'$ of the prior art.

The operation of the protecting transistor Q3 will be also understood from the curve V(M) in the voltage versus time chart of Fig. 4.

In the above-described operation of the device of Fig. 5, the base of the protecting transistor Q3 is in a floating state. The transistor Q3 is turned ON when the voltage between the collector and the emitter is greater than the breakdown voltage, and thus the voltage applied to the collector is discharged to the voltage source $V_{SS}$. Accordingly, the protecting transistor is not destroyed.

In the device of Fig. 5, it is possible to reduce the breakdown voltage of the protecting transistor Q3 to as low as 10 volts. Since the protecting transistor Q3 is a bipolar type, the restriction in the design of the transistor is less than in the case of a MIS type transistor, and accordingly, it is relatively easy to design a protection circuit including a protecting transistor having such a reduced breakdown voltage.

In the structure of the device of Fig. 5, the distance d between the collector and the emitter of the protecting transistor Q3 should be as small as possible, and the area of the collector of the protecting transistor Q3 should be as large as possible. As the distance "d" between the collector and the emitter decreases, the current amplification factor $\beta$ of the bipolar transistor increases, and thus the current increases, and accordingly, the protection effect is increased. As the area of the collector increases, the area of the border increases, and thus the junction electrostatic capacitance in the case of a reverse bias increases, and therefore, the coupling capacitance is increased, and accordingly, the protection effect is increased.

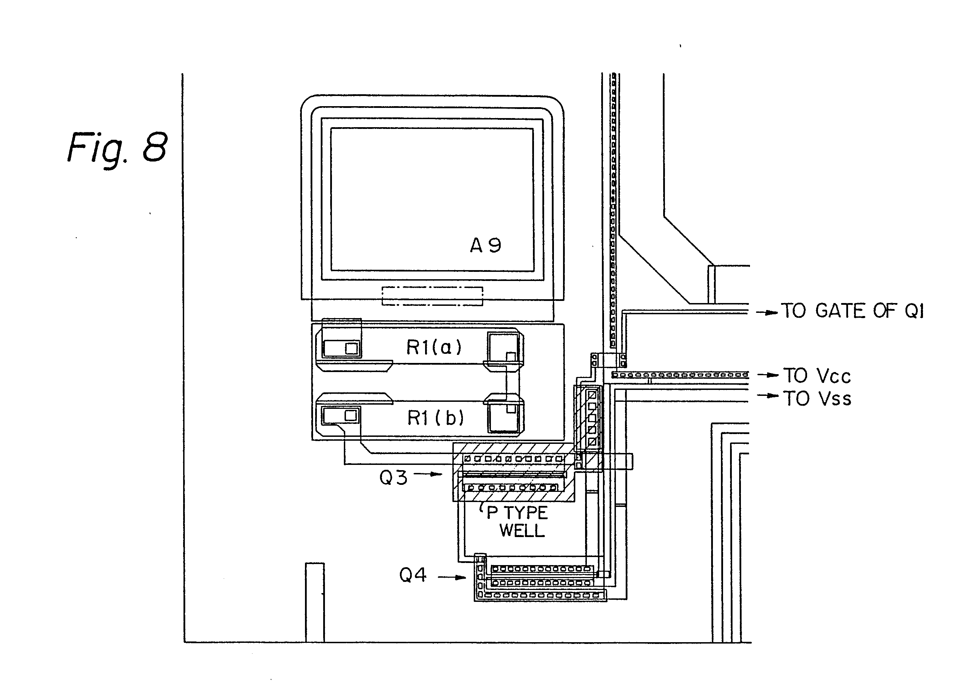

An example of an actual pattern of a protection circuit for a large-scale integrated circuit according to an embodiment of the present invention is shown in Fig. 8.

The pattern shown in Fig. 8 includes an input terminal conductor portion A9, an input resistor consisting of resistor members R1(a) and R1(b), a protecting transistor Q3 formed in a p-type well region, an auxiliary transistor Q4, conductors led to the gate of the transistor Q1 to be protected, and the voltage sources $V_{CC}$ and $V_{SS}$. The resistance of each of resistor members R1(a) and R1(b) is 585 ohms which provides a total resistance of 1170 ohms at the input resistor.

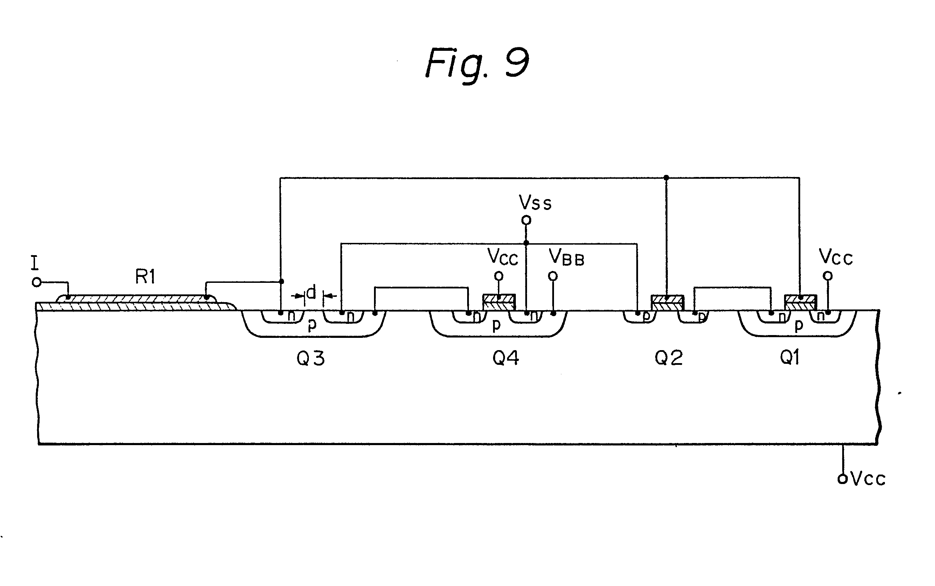

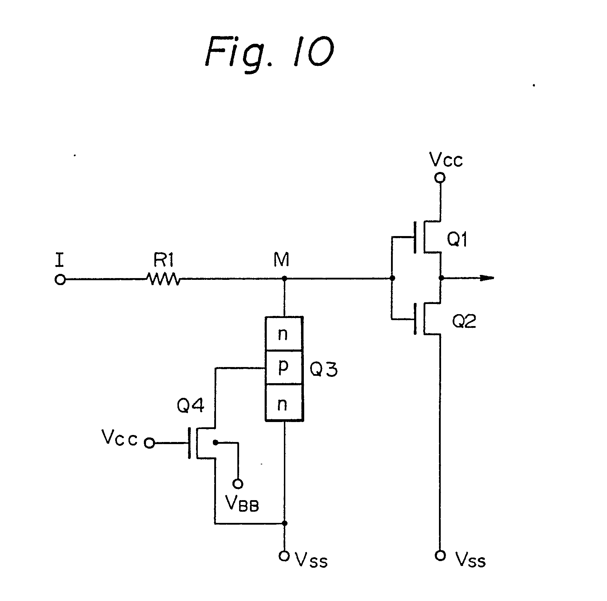

A protection circuit for a large-scale integrated circuit according to another embodiment of the present invention is shown in Figs. 9 and 10. The cross-sectional structure is shown in Fig. 9, and the equivalent circuit of the structure of Fig. 8 is shown in Fig. 10.

In the structure shown in Fig. 9, the metal insulator semiconductor transistor is constituted by complementary MIS transistors Q1 and Q2. The gates of the transistors are connected in common to one terminal of the input resistor R1. The protective operation of the device of Fig. 9 is fundamentally the same as that of the device of Fig. 5.

In the manufacturing process of the integrated circuit device having the complementary MIS transistors Q1 and Q2 and the protection circuit as shown in Fig. 9, the base region of the protecting transistor Q3 and the well region of the transistor Q4 can be formed simultaneously with the formation of the well region of the complementary MIS transistors Q1 and Q2, and the collector and emitter of the transistor Q3 and the source and drain of the transistor Q4 can be formed simultaneously with the formation of the complementary MIS transistors Q1 and Q2. Accordingly, the manufacturing process of the integrated circuit device shown in Fig. 9 is advantageous in that it is possible to form an effective protecting circuit without the addition of any particular manufacturing steps.

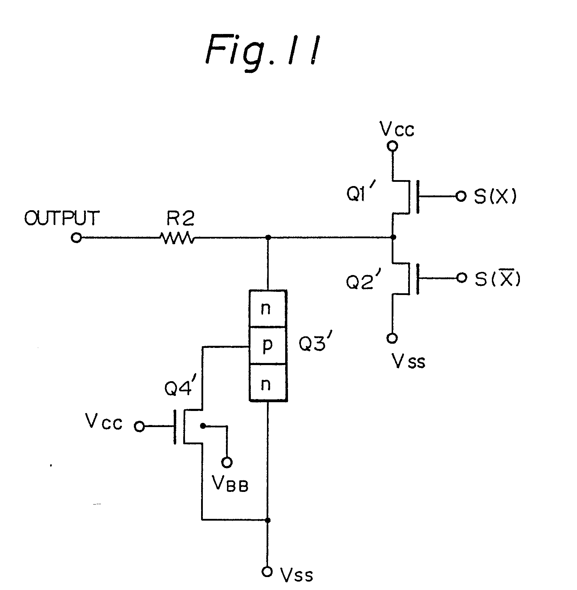

A protection circuit for a large-scale integrated circuit according to still another embodiment of the present invention is shown in Fig. 11. In the device of Fig. 11, the protective elements are arranged in the output terminal side. One terminal of a resistor R2 is connected to an output terminal OUTPUT. The resistance of the resistor R2 is, for example, 10 to 50 ohms. The other terminal of the resistor R2 is connected to the collector of the protecting transistor Q3' and the junction of the transistors Q1' and Q2' to be protected. The auxiliary transistor Q4' is connected between the base of the protecting transistor Q3' and the voltage source $V_{SS}$. The protective operation of the device of Fig. 11 is similar to that of the device of Fig. 5 or Fig. 8.

## Claims

1. A protection circuit for a large-scale integrated circuit comprising:

a metal insulator semiconductor transistor (Q1) to be protected;

a resistor (R1) connected between an external terminal (I) and the transistor (Q1) to be protected;

a protecting transistor (Q3) having a first electrode connected with the junctinon of the gate of the transistor (Q1) to be protected and the resistor, and a second connected to a voltage source ($V_{SS}$); and,

an auxiliary transistor (Q4) connected between a third electrode of the protecting transistor (Q3) and the voltage source ($V_{SS}$);

characterised in that the first electrode of the protecting transistor (Q3) is a collector, the second electrode is an emitter and the third electrode is a base formed in a well region formed in the substrate of the large-scale integrated circuit;

and in that the auxiliary transistor (Q4) causes the base of the protecting transistor (Q3) to have a floating state when the large-scale integrated circuit is not energized by a power source and causes the base of the protecting transistor (Q3) to become conductive with the voltage source ($V_{SS}$) when the large-scale integrated circuit is energized by the power source ($V_{CC}$).

2. A protection circuit according to claim 1, wherein the transistor to be protected (Q1) and the auxiliary transistor (Q4) are metal insulator semiconductor transistors, and the protecting transistor is a lateral bipolar transistor.

3. A protection circuit according to claim 1 or 2, wherein the resistor (R1) is constituted by a diffusion resistor region formed in the substrate of the large-scale integrated circuit.

4. A protection circuit according to any one of the preceding claims, wherein the transistor to be protected is constructed in the form of complementary metal insulator semiconductor transistors (Q1,Q2; Q1',Q2'), the gates of which are connected in common.

5. A protection circuit according to any one of the preceding claims, wherein the external terminal (I) to which the resistor (R1) is conected is an input terminal pad (A9) of the large-scale integrated circuit.

6. A protection circuit according to any one of claims 1 to 4, wherein the external terminal (I) to which the resistor is connected is an output terminal of the large-scale integrated circuit.

*Fig. 1*

*Fig. 2*

# Fig. 3

0 257 774

## Fig. 4

## Fig. 5

# Fig. 6

I○ — R1 — M ·

Vcc ○

Q1

n
p  Q3
n

Q4

Vcc ○

○
V_{BB}

Vss ○         Vss ○

# Fig. 7

COLLECTOR-EMITTER CURRENT OF Q3

V_B    POTENTIAL OF COLLECTOR OF Q3

Fig. 8

→ TO GATE OF Q1

→ TO Vcc
→ TO Vss

A 9

R1(a)

R1(b)

Q3 →

P TYPE
WELL

Q4 →

0 257 774

# Fig. 9

# Fig. 10

# Fig. 11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | PATENT ABSTRACTS OF JAPAN, vol. 5, no. 70 (E-56)[742], 12th May 1981; & JP-A-56 19 656 (MITSUBISHI DENKI K.K.) 24-02-1981 * Figure; abstract * | 1 | H 01 L 27/02 |
| A | Idem | 2 | |
| Y | US-A-3 746 946 (MOTOROLA INC.) * Figure 1; page 4, column 4, lines 5-11 * | 1 | |
| Y | EP-A-0 055 552 (FUJITSU LTD) * Page 5, lines 11-12; figures 1,2 * | 1 | |
| A | * Figure 6 * | 3 | |
| A | IBM TECHNICAL DISCLOSURE BULLETIN, vol. 13, no. 2, July 1970, page 315, New York, US; R.G. GLADU: "Use of lateral NPN devices for interfacing FET circuits" * Figures; page 315, lines 7-8 * | 2 | |
| A | PATENT ABSTRACTS OF JAPAN, vol. 7, no. 88 (E-170)[1233], 12th April 1983; & JP-A-58 14 562 (TOKYO SHIBAURA DENKI K.K.) 27-01-1983 * Figure; abstract, lines 13-14 * | 4,5 | TECHNICAL FIELDS SEARCHED (Int. Cl.4)<br><br>H 01 L |
| A | PATENT ABSTRACTS OF JAPAN, vol. 7, no. 182 (E-192)[1327], 11th August 1983; & JP-A-58 86 773 (NIPPON DENKI K.K.) 24-05-1983 * Figure a; abstract, line 1 * | 6 | |

The present search report has been drawn up for all claims

| Place of search | Date of completion of the search | Examiner |
|---|---|---|
| THE HAGUE | 25-11-1987 | JUHL A. |